# EUROPÄISCHE PATENTSCHRIFT

(11) **EP 4 027 522 B1**
(45) Veröffentlichungstag und Bekanntmachung des Hinweises auf die Patenterteilung: **02.07.2025**
(21) Anmeldenummer: 21150801.5
(22) Anmeldetag: 08.01.2021
(51) Int. Cl.: H03K 17/96

(54) **VERFAHREN ZUR HERSTELLUNG UND MONTAGE EINER BEDIENEINRICHTUNG UND BEDIENEINRICHTUNG**
OPERATING DEVICE AND METHOD FOR MANUFACTURING AND ASSEMBLING AN OPERATING DEVICE
PROCÉDÉ DE FABRICATION ET DE MONTAGE D'UN DISPOSITIF DE COMMANDE ET DISPOSITIF DE COMMANDE

(43) Veröffentlichungstag der Anmeldung: 13.07.2022
(73) Patentinhaber: Hoffmann + Krippner GmbH, 74722 Buchen (DE)
(72) Erfinder: Arend, Jens, 60389 Frankfurt am Main (DE); Robel, Gilbert, 61440 Oberursel (Taunus) (DE); Schnur, Jens, 64760 Oberzent (DE); Watzlawek, Marcel, 74746 Höpfingen (DE)
(74) Vertreter: Habermann Intellectual Property Partnerschaft von Patentanwälten mbB

(56) Entgegenhaltungen:
- DE-A1- 102008 047 325
- DE-A1- 102012 010 321
- DE-A1- 102013 214 162
- DE-A1- 102018 200 536
- DE-A1- 102018 200 538
- DE-B4- 102013 214 162

## Beschreibung

Die Erfindung betrifft ein Verfahren zur Herstellung und Montage einer Bedieneinrichtung nach Anspruch 1 und eine Bedieneinrichtung nach Anspruch 10.

Aus der Praxis sind unterschiedliche Bedieneinrichtungen mit kapazitiven Sensoren zum Erfassen einer Berührung oder Annäherung an ein Bedienfeld der Bedieneinrichtung bekannt. Typische Beispiele sind berührungsempfindliche Bildschirme, die die Berührung des Bildschirmes an der betreffenden Stelle erfassen, lokalisieren und auswerten können. Im Vergleich zu den regelmäßig komplexen berührungsempfindlichen Bildschirmen bieten einfache Tastelemente oder andere berührungsempfindliche Bedienelemente eines Bedienfeldes eine relativ einfache und kosteneffiziente Möglichkeit einfache Anwendereingaben des Bedienfeldes zu erfassen. Dabei kann sich um Bedieneinrichtungen für Alltagsgeräte beispielsweise aus den Bereichen der Unterhaltungselektronik oder der Gebäudetechnik handeln, die keine komplexe Anwenderinteraktionen benötigen, um ihrer bestimmungsgemäßen Funktion nachzukommen. Es ist ebenfalls möglich und vor allem bei Anlagen oder Maschinen in der Medizintechnik, der Dentaltechnik oder der Lebensmittelindustrie vorteilhaft, eine Bedieneinrichtung berührungssensitiv auszugestalten, um dadurch auch über einen lange andauernden Nutzungszeitraum hinweg hohe Hygienestandards erfüllen zu können.

Berührungsempfindliche Bedienelemente haben gegenüber den klassischen kontaktbehafteten Schaltelementen und Tastern den großen Vorteil, dass keine einem Verschleiß unterliegenden mechanischen Schaltvorgänge stattfinden, sodass die Nutzungsdauer berührungsempfindlicher Bedieneinrichtungen erheblich gesteigert werden kann. Zusätzlich ist eine für die Verarbeitung der Anwenderinteraktionen benötigte Elektronik bei berührungsempfindlichen Bedienelementen von außen vor Verschmutzungen geschützt, denn es bedarf keiner Spalte und Schlitze mehr für die Schaltelemente, durch die die Verschmutzungen in die Bedieneinrichtung eindringen können.

Berührungsempfindlichen Bedieneinrichtungen weisen oftmals ein kapazitives Sensorelement auf, welches eine Kapazitätsveränderung erfassen und in elektronische Signale umsetzen kann. Dabei misst die Elektronik in der berührungsempfindlichen Bedieneinrichtung über das kapazitive Sensorelement eine Veränderung einer durch einen Spannungsabfall zwischen zwei Elektroden erzeugten elektrischen Kapazität in der Umgebung des Bedienfeldes, in der das kapazitive Sensorelement in der Bedieneinrichtung angeordnet ist. Nähert sich ein Anwender dem Bedienfeld oder berührt er dieses mit seinem Körper, ändert eine Annäherung an das Bedienfeld oder eine Berührung des Bedienfelds den Ladungszustand der aufgeladenen Elektroden und damit die mit dem kapazitiven Sensorelement messbare Kapazität, was entweder absolut als auch im Verhältnis zu einem Referenzkondensator gemessen und ausgewertet werden kann. Dadurch kann die Elektronik eine Anwenderinteraktion mit dem jeweiligen kapazitiven Sensorelement erkennen und reagieren.

Derartige berührungsempfindlichen Bedieneinrichtungen sind aufgrund des kapazitiven Sensors und der erforderlichen Auswerteelektronik komplexer und somit auch kostenintensiver als Bedieneinrichtungen mit mechanischen Schaltelementen. Gleichwohl wird wegen verschiedener Vorteile angestrebt, berührungsempfindliche Bedieneinrichtungen für viele Anwendungsbereiche einzusetzen, was durch eine kosteneffiziente und einfache Herstellung begünstigt wird.

Aus der Druckschrift DE 10 2015 015 927 A1 ist ein berührungsempfindlicher Taster bekannt, der eine Abdeckplatte aufweist, die auf einer einem Benutzer zugewandten Vorderseite ein Bedienungsfeld definiert und zumindest im Bereich des Bedienungsfeldes elektrisch isolierend und wenigstens teilweise lichtdurchlässig ausgebildet ist. Zudem weist der berührungsempfindliche Taster eine Trägerplatte auf, die auf einer dem Benutzer abgewandten Seite der Abdeckplatte mit einem Abstand zu dieser angeordnet ist und eine elektrische Kontaktfläche aufweist. Der Abstand zwischen der Trägerplatte und der Abdeckplatte ist erforderlich, damit ein auf der Trägerplatte angeordnetes Leuchtmittel einen Bedienbereich der Abdeckplatte möglichst gleichmäßig ausleuchten kann. Ein Kopplungselement, das zwischen der Abdeckplatte und der Trägerplatte dem Bedienungsfeld korrespondierend angeordnet ist und mit der elektrischen Kontaktfläche der Trägerplatte elektrisch leitend in Kontakt steht, weist einen elektrisch leitfähigen, lichtundurchlässigen Hohlkörper auf, wobei der Hohlkörper mit der elektrischen Kontaktfläche der Trägerplatte elektrisch leitend in Kontakt steht und einen Hohlraum aufweist, der sich in einer Richtung zwischen der Trägerplatte und der Abdeckplatte erstreckt. Außerdem ist eine Lichtquelle so auf der Trägerplatte montiert, dass ein von ihr emittiertes Licht in Richtung zur Abdeckplatte in den Hohlraum des Hohlkörpers des Kopplungselements einkoppelt. Die einzelnen Elemente derartiger berührungsempfindlicher Taster werden typischerweise miteinander verklebt oder verschraubt. Die einzelnen Komponenten miteinander zu verschrauben kann einen zusätzlichen Herstellungs- und Montageaufwand bedeuten. Miteinander verklebte Komponenten können üblicherweise nicht mehr zerstörungsfrei für Wartungs- oder Reparaturzwecke auseinandergenommen werden.

In DE 10 2012 010 321 A1 oder in DE 10 2018 200 536 A1 ist jeweils eine Bedienvorrichtung gezeigt und beschrieben, bei der zwischen einer Leiterplatte mit einem kapazitiven Sensorelement einerseits und einem als Kochfeldplatte ausgebildeten Bedienfeld andererseits ein Kopplungselement Vor diesem Hintergrund liegt der Erfindung die Aufgabe zugrunde, ein Verfahren bereitzustellen, mit dem kosteneffiziente, einfach zu reparierende und einfach zu wartende berührungsempfindliche Bedieneinrichtungen hergestellt und montiert werden können.

Diese Aufgabe wird erfindungsgemäß dadurch gelöst, dass auf der Leiterplatte mehrere kapazitive Sensorelemente angeordnet werden, dass in dem Kopplungselementanordnungsschritt mehrere elektrisch leitende Kopplungselemente an oder in dem mit einem Spritzgussverfahren aus Kunststoff hergestellten Grundkörper ausgebildet oder eingebettet werde, und dass der Grundkörper aus einem lichtundurchlässigen Kunststoffmaterial hergestellt wird und dass die Kopplungselemente in dem Kopplungselementanordnungsschritt derart ausgebildet werden, dass die Kopplungselemente einen sich von der Leiterplatte bis zu einer Ausnehmung in der Anlagefläche des Grundkörpers erstreckenden Hohlraum mit einer lichtundurchlässigen Umwandung hülsenförmig umgeben.

Ein wesentlicher Vorteil wird dabei darin gesehen, dass mit dem erfindungsgemäßen Herstellungsverfahren ein einstückiges Grundkörperkopplungselement hergestellt wird, welches sowohl den Grundkörper als auch die Kopplungselemente umfasst, sodass anschließend lediglich ein einzelnes Grundkörperkopplungselement bevorratet und montiert werden muss. Die Montage ist darüber hinaus besonders einfach und kostengünstig, da die Leiterplatte lediglich an das Grundkörperkopplungselement angedrückt und in einer geeigneten Weise daran festgelegt werden muss. Der Aufwand bei der Montage beschränkt sich demzufolge auf die Handhabung von zwei Komponenten. Auch und insbesondere für eine spätere Demontage, wie sie beispielsweise für eine Wartung oder einen Reparaturfall erforderlich ist, ist die Herstellung eines kombinierten Grundkörperkopplungselements besonders vorteilhaft, da die Leiterplatte in einfacher Weise von dem Grundkörperkopplungselement gelöst und ausgetauscht werden kann, ohne dass sich einzelne Kopplungselemente lösen oder anschließend deren Position relativ zu der ausgetauschten Leiterplatte wieder präzise vorgegeben werden muss.

Weder beim Kopplungselementanordnungsschritt noch beim Festlegen der Leiterplatte an dem Grundkörper wird eine Verklebung benötigt. Das in der Bedieneinrichtung verborgene kapazitive Sensorelement ist in der Bedieneinrichtung angeordnet und geschützt. Anwenderinteraktionen sind dennoch von dem kapazitiven Sensorelement erfassbar, da das elektrisch leitende Kopplungselement eine Anwenderinteraktion an das kapazitive Sensorelement weiterleiten kann. Das Grundkörperkopplungselement kann formschlüssig sowohl mit der Leiterplatte als auch gegebenenfalls mit dem Bedienfeld rastend oder schraubend festgelegt werden. Optional denkbar ist aber auch zusätzlich oder alternativ hierzu ein Verkleben.

Die durch das erfindungsgemäße Verfahren hergestellte Bedieneinrichtung ist schneller, kostengünstiger und effizienter herstellbar als andere aus dem Stand der Technik bekannte Bedieneinrichtungen. Erfindungsgemäße Bedieneinrichtungen können ganz allgemein zur Bedienung von Maschinen und Geräten sowohl im industriellen Einsatz als auch im privaten Umfeld eingesetzt werden. Derartige Bedieneinrichtungen eignen sich beispielsweise für die Gebäudetechnik und Smart-Home-Anwendungen sowie für Geräte der Unterhaltungselektronik. Da keine beweglichen Komponenten erforderlich sind und die Bedieneinrichtungen vollständig geschlossene Oberflächen aufweisen können eignen sich derartige Bedieneinrichtungen insbesondere für Geräte oder Maschinen, bei denen hohe Anforderungen an die Hygiene oder Sauberkeit gestellt werden, wie beispielsweise in der Medizintechnik oder Dentaltechnik, bzw. in Arztpraxen oder Krankenhäusern, oder im Bereich der Lebensmittelindustrie.

Ein weiterer Vorteil wird darin gesehen, dass die Leiterplatte mit mindestens einer Leuchtquelle zur Beleuchtung des Bedienfelds bestückt werden kann. Der Abstand zwischen der Leiterplatte und dem Bedienfeld kann ausreichend groß vorgegeben und durch die Kopplungselemente überbrückt werden, sodass auf der Leiterplatte nicht nur eine Leuchtquelle wie beispielsweise eine LED angeordnet werden kann, sondern auf Grund des ausreichenden Abstands auch einen dafür vorgesehenen Bereich des Bedienfelds homogen ausleuchten kann.

Für eine besonders effektive Ausleuchtung des Bedienfeldes ist vorgesehen, dass der Grundkörper aus einem lichtundurchlässigen Kunststoffmaterial hergestellt wird und dass die Kopplungselemente in dem Kopplungselementanordnungsschritt derart ausgebildet werden, dass die Kopplungselemente einen sich von der Leiterplatte bis zu einer Ausnehmung in der Anlagefläche des Grundkörpers erstreckenden Hohlraum mit einer lichtundurchlässigen Umwandung hülsenförmig umgeben. Das lichtundurchlässige Kunststoffmaterial schottet die mindestens eine in dem Hohlraum angeordnete Leuchtquelle auf der Leiterplatte gegenüber anderen Lichtquellen und insbesondere gegenüber benachbarten Leuchtquellen auf der Leiterplatte ab, sodass das von der Leuchtquelle beleuchtete Bedienfeld kontrastreich und dennoch homogen ausgeleuchtet werden kann. Die hülsenförmige Umwandung ermöglicht eine gezielte Ausleuchtung des stirnseitig befindlichen Bereichs des Bedienfeldes von der Leiterplatte aus.

Gemäß einer besonders einfachen Ausgestaltung des erfindungsgemäßen Verfahrens kann vorgesehen sein, dass in dem Kopplungselementanordnungsschritt die elektrisch leitfähigen Kopplungselemente jeweils als metallisches Einlegeteil in eine Spritzgussform eingelegt und während der Herstellung des Grundkörpers in dieser Spritzgussform an oder in diesem Grundkörper eingebettet werden. Durch diese besonders einfache Ausgestaltung lässt sich die Bedieneinrichtung besonders kostengünstig herstellen. Die elektrisch leitfähigen Kopplungselemente können dabei eine hülsenförmige Zylinderform aufweisen, die von dem Grundkörper umhüllt oder darin eingebettet ist. Gegebenenfalls können die elektrisch leitfähigen Kopplungselemente seitlich abstehende Zungen bzw. Vorsprünge oder einen seitlich abstehenden Flansch aufweisen, um das jeweilige Kopplungselement in dem Grundkörper zuverlässig zu verankern.

Eine besonders vorteilhafte elektrische Kopplung über das metallische Einlegeteil zum kapazitiven Sensorelement kann nach einer optionalen Ausgestaltung des erfindungsgemäßen Verfahrens dadurch erreicht werden, dass die elektrisch leitfähigen Kopplungselemente derart in an oder in dem Grundkörper eingebettet werden, dass eine Kontaktfläche der elektrisch leitfähigen Kopplungselemente für einen Kontakt mit dem kapazitiven Sensorelement von außen elektrisch leitend kontaktierbar ist. Eine Kapazitätsänderung wird durch einen unmittelbar elektrisch leitenden Kontakt zwischen dem elektrisch leitfähigen Kopplungselement und der Kontaktfläche des Sensorelements besonders gut übertragen, sodass die elektrische Kontaktierung der Kontaktfläche die Einkopplung der kapazitiven Wirkung der Bedieneinrichtung erhöht.

Es ist jedoch auch denkbar, dass die elektrisch leitfähigen Kopplungselemente keinen unmittelbaren elektrisch leitenden Kontakt zu einem zugeordneten Sensorelement aufweisen, sondern die Sensorelemente beispielsweise durch eine isolierende Beschichtung oder eine Beschichtung mit Lötstopplack überzogen ist und das elektrisch leitfähige Kopplungselement jeweils an der Beschichtung anliegt. Es ist ebenfalls möglich, dass die elektrisch leitfähigen Kopplungselemente lediglich bis in die Nähe des Sensorelements heranragen und in einem Abstand zu der Leiterplatte und dem darauf angeordneten Sensorelement angeordnet sind, um beispielsweise allseitig von dem Grundkörper umhüllt zu sein, sodass das durch eine Ladungsverschiebung erzeugte elektrische Signal etwas verstärkt wird.

Es ist optional ebenfalls möglich, dass in dem Kopplungselementanordnungsschritt der Grundkörper mit den Kopplungselementen mit einem Spritzgussverfahren aus einem elektrisch nicht leitfähigen Kunststoffmaterial hergestellt wird, und dass anschließend in einem Beschichtungsschritt die Kopplungsflächen der Kopplungselemente mit einer elektrisch leitfähigen Beschichtung beschichtet werden. Das Maskieren einzelner Bereiche und das selektive Beschichten der Kopplungsflächen der Kopplungselemente ist mit verschiedenen Verfahren möglich, die beispielsweise aus der Beschichtungstechnik bekannt sind. Durch eine Beschichtung einer Kopplungsfläche mit einem elektrisch leitfähigen Material kann mit geringem Materialaufwand eine hohe elektrische Leitfähigkeit über die Kopplungsfläche hinweg erzeugt werden, um die Information über eine Annäherung an das Bedienfeld oder eine Berührung des Bedienfeldes über die Erstreckung der Kopplungsfläche hinweg von dem Bedienfeld an das zugeordnete Sensorelement zu übertragen.

Es ist grundsätzlich ebenfalls denkbar, dass der Grundkörper mit den Kopplungselementen aus einem elektrisch leitfähigen Kunststoffmaterial hergestellt wird und anschließend alle relevanten Oberflächen außerhalb der Kopplungsflächen mit einer elektrisch nicht leitfähigen Beschichtung überzogen werden. Diese Variante kann beispielsweise vorteilhaft sein, wenn Kunststoffmaterialien mit einer hohen elektrischen Leitfähigkeit eingesetzt werden können und zudem lediglich ein einziges Sensorelement benötigt wird. Gegebenenfalls können auch einzelne Bereiche an der Oberfläche des Grundkörpers mit elektrisch nicht leitenden Beschichtungen überzogen oder mit Trennzonen abgegrenzt werden, um den aus dem elektrisch leitfähigen Kunststoffmaterial hergestellten Grundkörper für mehrere Sensorelemente nutzen zu können.

Gemäß einer vorteilhaften Ausgestaltung des Erfindungsgedankens ist vorgesehen, dass in dem Kopplungselementanordnungsschritt der Grundkörper mit einem 2K-Spritzgussverfahren hergestellt wird, wobei mindestens eine Kopplungsfläche der Kopplungselemente mit einem elektrisch leitfähigen Kunststoffmaterial und der Grundkörper aus einem nicht elektrisch leitfähigen Kunststoffmaterial ausgebildet wird. Die Herstellung des Grundkörperkopplungselements als Kombination des Grundkörpers mit den Kopplungselementen in einem einzigen Verfahrensschritt durch ein 2K-Spritzgussverfahren ist besonders kostengünstig und einfach. Da 2K-Spritzgussverfahren bereits bekannt und bewährt sind kann das Grundkörperkopplungselement zuverlässig und im Wesentlichen ohne Ausschuss hergestellt werden. In Abhängigkeit von der elektrischen Leitfähigkeit des verwendeten elektrisch leitfähigen Kunststoffmaterials kann das jeweilige Volumen der Kopplungselemente so vorgegeben werden, dass eine ausreichende Übertragung des Signals von dem Bedienfeld an das Sensorelement bewirkt werden kann.

Das Grundkörperkopplungselement kann auch dadurch hergestellt werden, dass nach einer optionalen Ausgestaltung des erfindungsgemäßen Verfahrens vorgesehen ist, dass in dem Kopplungselementanordnungsschritt der Grundkörper mit einem 2K-Spritzgussverfahren hergestellt wird, wobei eine Kopplungsfläche der Kopplungselemente mit einem galvanisierbaren Kunststoffmaterial und der Grundkörper aus einem nicht galvanisierbaren Kunststoffmaterial ausgebildet wird, und anschließend in einem Beschichtungsschritt die Kopplungsfläche der Kopplungselemente mit einer elektrisch leitfähigen Beschichtung galvanisiert wird. Der mit einer geeigneten Werkzeugform in der 2K-Spritzgusstechnik hergestellte Grundkörper aus zwei verschiedenen Kunststoffmaterialien kann überwiegend aus einem nicht galvanisierbaren Kunststoffmaterial bestehen, wobei ausschließlich die von außen zugängliche Kopplungsfläche der Kopplungselemente aus einem zweiten und galvanisierbaren Kunststoffmaterial besteht. Anschließend kann der gesamten Grundkörper mit einer elektrisch leitfähigen Beschichtung galvanisiert werden, wobei dann die elektrisch leitfähige Beschichtung ausschließlich an den Kopplungsflächen der Kopplungselemente ausgebildet wird und haften bleibt, während andere Oberflächenbereiche des überwiegend aus nicht galvanisierbaren Kunststoff hergestellten Grundkörpers nicht beschichtet werden. Das nicht galvanisierbare Kunststoffmaterial ist dabei zweckmäßigerweise nicht elektrisch leitend und vorzugsweise lichtundurchlässig. Durch den Galvanisierungsvorgang kann mit geringem Materialaufwand eine qualitativ hochwertige und besonders leitfähige elektrisch leitende Beschichtung der Kopplungsflächen der Kopplungselemente erzeugt werden.

Auf ein metallisches Einlegeteil, welches als Kopplungselement dienen kann, kann dann verzichtet werden, wenn nach dieser Ausgestaltung das Kopplungselement direkt galvanisiert wird und seine Oberfläche elektrisch leitfähig wird. Dadurch kann ein weiterer Kostenpunkt reduziert werden, denn die gesonderte Herstellung und anschließende Handhabung metallischer Einlegeteile, die von einem Kunststoffmaterial umspritzt werden müssen, sind generell mit mehr Aufwand und Kosten verbunden als die Herstellung eines 2K-Grundkörpers mit aus der Praxis bekannten und häufig eingesetzten 2K-Spritzgussverfahren.

Es ist grundsätzlich möglich, an Stelle eines Galvanisierungsverfahrens auch ein beliebiges anderes Beschichtungsverfahren zu verwenden, um einen metallischen Überzug einer Oberfläche bzw. der Kopplungsflächen des Grundkörperkopplungselements zu erzeugen. Eine Galvanisierung dürfte für viele Anwendungsbereiche vorteilhafte Eigenschaften aufweisen. Es ist jedoch erfindungsgemäß denkbar, dass eine elektrisch leitfähige Beschichtung auch mit einem anderen bekannten Verfahren wie beispielsweise Aufdrucken oder Aufkleben auf die Kopplungsflächen aufgebracht werden kann, sofern beispielsweise die Kopplungsflächen einfach von außen zugänglich sind.

Gemäß einer vorteilhaften Ausgestaltung des erfindungsgemäßen Verfahrens ergibt sich für das kapazitive Sensorelement eine verbesserte elektrische Kopplung, wenn vorgesehen ist, dass die Kopplungsflächen der Kopplungselemente so ausgebildet werden, dass die elektrisch leitfähige Beschichtung für einen Kontakt mit dem kapazitiven Sensorelement von außen elektrisch leitend kontaktierbar ist. Ebenfalls nach dieser Ausgestaltung verbessert sich die kapazitive Einkopplung der elektrisch leitfähigen Kopplungselemente, wenn diese mit einer weiteren elektrisch leitfähigen Kontaktfläche in Verbindung stehen, die beispielsweise in der Umgebung des jeweiligen Kopplungselements und benachbart zu dem zugeordneten Sensorelement ausgebildet ist. Die Kapazität der Kopplungselemente kann dadurch vergrößert und die Empfindlichkeit des zugeordneten Sensorelements verbessert werden. Dabei kann die Kontaktfläche ebenfalls von dem Bedienfeld von dem Anwender beabstandet sein, sodass die Anwenderinteraktion kapazitiv zu dem Sensorelement wirkt.

Optional kann das erfindungsgemäße Verfahren derart ausgestaltet sein, dass in einem Bedienfeldanordnungsschritt ein Bedienelementkörper mit dem Grundkörper, mit den Kopplungselementen und mit einer Bedienfeldplatte mit einem 3K-Spritzgussverfahren hergestellt wird und anschließend der Beschichtungsschritt durchgeführt wird. Die Bedienfeldplatte kann dabei aus einem anderen Kunststoffmaterial als der Grundkörper hergestellt werden und ist in vorteilhafter Weise sowohl transparent als auch nicht elektrisch leitend ausgestaltet. Die Bedienfeldplatte soll eine dekorative Abdeckung für die erfindungsgemäße Bedieneinrichtung bilden, die sich in ästhetisch ansprechender Weise in ein Gehäuse eines elektrisch bedienbaren Geräts oder in eine Wandfläche beispielsweise eines Möbelstücks einfügen lässt. Optional kann die Bedienfeldplatte auch aus Glas oder aus einem anderen Material gesondert hergestellt sein und anschließend mit dem Grundkörperkopplungselement verbunden oder verklebt werden, wobei auch eine rastend klemmende Mechanik denkbar ist, die das Grundkörperkopplungselement an der Bedienfeldplatte festlegt.

Die mehreren kapazitiven Sensorelemente ermöglichen eine vielfältige Anwenderinteraktion mit mehreren Optionen. Auf diese Art können komplexe Bedienfelder mit dem erfindungsgemäßen Verfahren hergestellt und konstruiert werden.

Es kann vorzugsweise je Sensor ein Kopplungselement verwendet werden, sodass eine Anzahl von unabhängig voneinander betätigbaren berührungssensitiven Schaltern gebildet wird. Es ist auch denkbar, mehrere Sensoren für ein einzelnes Kopplungselement zu verwenden, um dessen Betätigung besonders sensitiv oder differenziert erfassen zu können. Weiterhin ist es auch möglich, mehrere Kopplungselemente mit einem einzigen Sensorelement zu kombinieren. Die mehreren Kopplungselemente können beispielsweise einen größeren Bedienflächenbereich erfassen, ohne selbst eine entsprechende Größe aufweisen zu müssen. Es ist ebenfalls denkbar, dass ein ortsauflösendes Sensorelement mit mehreren beabstandet zueinander angeordneten Kopplungselementen kombiniert wird, um dadurch unterschiedliche Bedienungsmöglichkeiten unterscheiden und entsprechend auswerten zu können.

Optional kann für das erfindungsgemäße Verfahren vorgesehen sein, dass in dem Montageschritt der Grundkörper mit der Anlagefläche an eine Bedienfeldplatte angeklebt wird. Gemäß dieser Ausgestaltung kann die erfindungsgemäße Bedieneinrichtung und das Bedienfeld sicher und robust aneinander festgelegt werden. Die Bedienfeldplatte kann aus Glas bestehen, wobei ein Verbindungsvorgang mit einer ansonsten fertig vormontierten Bedieneinrichtung einfach durchführbar ist.

Die Erfindung betrifft auch eine Bedieneinrichtung, die kosteneffizient hergestellt werden kann sowie einfach zu reparieren und einfach zu warten ist. Aus der Praxis sind Bedieneinrichtungen mit mindestens einem kapazitiven Sensorelement zum Erfassen einer Berührung oder Annäherung an ein Bedienfeld der Bedieneinrichtung bekannt, wobei die Bedieneinrichtung einen Grundkörper und eine Leiterplatte aufweist, wobei der Grundkörper mit einer Anlagefläche an einer Kontaktfläche des Bedienfelds festgelegt werden kann, wobei die Leiterplatte in einem Abstand zu der Anlagefläche an dem Grundkörper angeordnet und festgelegt werden kann, wobei zwischen der Anlagefläche des Grundkörpers und dem mindestens einen kapazitiven Sensorelement, welches auf der Leiterplatte angeordnet ist, mindestens ein elektrisch leitendes Kopplungselement angeordnet ist, um eine Kapazitätsänderung im Bereich des Bedienfelds zu dem mindestens einen kapazitiven Sensorelement zu übertragen, wobei das mindestens eine Kopplungselement an oder in dem mit einem Spritzgussverfahren aus Kunststoff hergestellten Grundkörper ausgebildet oder eingebettet ist und ein einstückiges Grundkörperkopplungselement bildet, und wobei die Leiterplatte an dem Grundkörperkopplungselement festgelegt ist und dabei das mindestens eine kapazitive Sensorelement an das mindestens eine elektrisch leitende Kopplungselement angedrückt ist.

Erfindungsgemäß ist vorgesehen, dassauf der Leiterplatte mehrere kapazitive Sensorelemente angeordnet sind, dass mehrere elektrisch leitende Kopplungselemente an oder in dem mit einem Spritzgussverfahren aus Kunststoff hergestellten Grundkörper ausgebildet oder eingebettet sind, und dass der Grundkörper aus einem lichtundurchlässigen Kunststoffmaterial hergestellt ist und dass die Kopplungselemente derart ausgebildet sind, dass die Kopplungselemente einen sich von der Leiterplatte bis zu einer Ausnehmung in der Anlagefläche des Grundkörpers erstreckenden Hohlraum mit einer lichtundurchlässigen Umwandung hülsenförmig umgeben. Die erfindungsgemäße Bedieneinrichtung ist besonders kostengünstig und ermöglicht auch eine einfache Montage bzw. Demontage, wodurch die erfindungsgemäße Bedieneinrichtung nicht zerstört werden muss, da keine Klebung vorgesehen werden muss. Auf der Leiterplatte kann mindestens eine Leuchtquelle zur Beleuchtung des Bedienfelds angeordnet sein, sodass auch ein beleuchtetes Bedienfeld mit geringen Kosten und ohne zusätzliche Montageaufwand bereitgestellt werden kann.

Der Grundkörper ist aus einem lichtundurchlässigen Kunststoffmaterial hergestellt ist und die Kopplungselemente sind derart ausgebildet, dass die Kopplungselemente einen sich von der Leiterplatte bis zu einer Ausnehmung in der Anlagefläche des Grundkörpers erstreckenden Hohlraum mit einer lichtundurchlässigen Umwandung hülsenförmig umgeben. Das lichtundurchlässige Kunststoffmaterial unterbindet eine Lichtausbreitung der Leuchtquelle in alle Richtungen und stellt somit einen Lichttunnel dar, mit dem das Bedienfeld von der Leiterplatte aus gesehen effektiv und zielgerichtet beleuchtet werden kann. Die hülsenförmige Umwandung kann eine kreisförmige oder ovale Querschnittsfläche begrenzen. Es ist ebenfalls möglich, dass die hülsenförmige Umwandung eine rechteckige oder polygonale Querschnittsfläche begrenzt. Die lichtundurchlässige Umwandung kann beispielsweise durch eine metallische Beschichtung erzeugt werden. Eine elektrisch leitfähige Beschichtung muss allerdings nicht notwendigerweise die gesamte Umwandung bedecken, sondern kann auch lediglich einen beispielsweise streifenförmigen Teilbereich bedecken. Die für eine gezielte Begrenzung der Beleuchtung vorteilhafte Lichtundurchlässigkeit der von dem Kopplungselement gebildeten Umwandung kann auch durch eine Beschichtung mit einem lichtundurchlässigen, jedoch elektrisch nicht leitenden Material bewirkt werden.

Nach einer vorteilhaften und einfachen Ausgestaltung der erfindungsgemäßen Bedieneinrichtung kann vorgesehen sein, dass die elektrisch leitfähigen Kopplungselemente jeweils als metallisches Einlegeteil an oder in diesem Grundkörper eingebettet sind. Metallische Einlegeteile sind generell kostengünstig und bedürfen zur deren Herstellung kaum Aufwand. Oftmals können diese metallischen Einlegeteile in hohen Stückzahlen vorproduziert und gelagert werden.

Optional kann vorgesehen sein, dass der Grundkörper mit einem Spritzgussverfahren aus einem nicht elektrisch leitfähigen Kunststoffmaterial hergestellt ist, und dass die Kopplungsflächen der Kopplungselemente mit einer elektrisch leitfähigen Beschichtung beschichtet sind. Die elektrisch leitfähige Beschichtung kann durch eine geeignete Maskierung und anschließende selektive Beschichtung der Kopplungsflächen erfolgen. Als Beschichtungsverfahren bietet sich eine Galvanisierung an. Es sind auch andere Beschichtungsverfahren denkbar und je nach Anwendungsfall vorteilhaft. So kann die elektrisch leitfähige Beschichtung beispielsweise auch aufgeklebt oder aufgedruckt sein kann. Es ist weiterhin auf möglich, dass die elektrisch leitfähige Beschichtung aufgedampft oder auflackiert wird.

Eine besonders einfache und gleichzeitig zuverlässige Herstellung des Grundkörperkopplungselements kann dadurch erfolgen, dass der Grundkörper mit einem 2K-Spritzgussverfahren hergestellt ist, wobei die Kopplungsflächen der Kopplungselemente aus einem elektrisch leitfähigen Kunststoffmaterial und der Grundkörper aus einem nicht elektrisch leitfähigen Kunststoffmaterial ausgebildet sind. Eine derartig ausgestaltete Bedieneinrichtung ist dann besonders vorteilhaft, wenn ein elektrisch gut leitfähiges Kunststoffmaterial mit einer hohen elektrischen Leitfähigkeit in dem 2K-Spritzgussverfahren verwendet werden kann, um eine Kopplungsfläche der Kopplungselemente mit einer hohen Kopplungsgüte zu erzeugen.

Nach einer besonders vorteilhaften Ausgestaltung der erfindungsgemäßen Bedieneinrichtung kann die elektrische Kopplung über die elektrisch leitfähigen Kopplungselemente in das zugeordnete kapazitive Sensorelement verbessert werden, wenn vorgesehen ist, dass die elektrisch leitfähigen Kopplungselemente derart in an oder in dem Grundkörper eingebettet sind, dass eine Kontaktfläche der elektrisch leitfähigen Kopplungselemente für einen Kontakt mit dem kapazitiven Sensorelement von außen elektrisch leitend kontaktierbar ist. Dadurch kann die kapazitive Kopplung von dem Bedienfeld zu dem jeweiligen kapazitiven Sensorelement erheblich verbessert werden und eine Bedienung durch Berührung oder Annäherung beispielsweise eines Fingers an das Bedienfeld zuverlässig erfasst werden.

Das Grundkörperkopplungselement kann besonders kosteneffizient sein, wenn nach einer optionalen Ausgestaltung der erfindungsgemäßen Bedieneinrichtung vorgesehen ist, dass der Grundkörper aus einem 2K-Spritzgussverfahren hergestellt ist, wobei die Kopplungsflächen der Kopplungselemente aus einem galvanisierbaren Kunststoffmaterial und der Grundkörper aus einem nicht galvanisierbaren Kunststoffmaterial ausgebildet sind, und die Kopplungsflächen der Kopplungselemente mit einer elektrisch leitfähigen Beschichtung galvanisiert sind. Das galvanisierbare Kunststoffmaterial ist dementsprechend vorteilhaft, da es günstiger ist als ein Metall und nur eine Oberfläche des Kopplungselements für die elektrische Leitfähigkeit benötigt wird.

Eine vorteilhaftere elektrische Kopplung in das kapazitive Sensorelement kann dadurch erreicht werden, wenn nach einer optionalen Ausgestaltung der erfindungsgemäßen Bedieneinrichtung vorgesehen ist, dass die Kopplungsflächen der Kopplungselemente so ausgebildet sind, dass die elektrisch leitfähige Beschichtung für einen Kontakt mit dem kapazitiven Sensorelement von außen elektrisch leitend kontaktierbar ist. Ebenfalls nach dieser Ausgestaltung der erfindungsgemäßen Bedieneinrichtung kann die kapazitive Einkopplung in die Bedieneinrichtung bzw. zu dem jeweiligen kapazitiven Sensorelement erheblich durch die Flächenvergrößerung verbessert werden.

Nach einer besonders vorteilhaften Ausgestaltung der erfindungsgemäßen Bedieneinrichtung kann vorgesehen sein, dass ein Bedienelementkörper mit dem Grundkörper, mit den Kopplungselementen und mit einer Bedienfeldplatte mit einem 3K-Spritzgussverfahren hergestellt ist. Der Bedienelementkörper kann zum Beispiel ganz oder teilweise durchsichtig ausgestaltet sein, sodass es die Bedieneinrichtung dekorativ abdecken kann. Der Bedienelementkörper kann optional auch verzierende Elemente aufweisen, die dem Anwender Informationen über das jeweilige Bedienfeldelement anzeigen.

Durch mehrere kapazitive Sensorelemente sind dementsprechend mehr Anwenderinteraktionen mit der erfindungsgemäßen Bedieneinrichtung möglich.

Nach einer vorteilhaften Ausgestaltung der erfindungsgemäßen Bedieneinrichtung kann vorgesehen sein, dass die Bedieneinrichtung eine Bedienfeldplatte aufweist und dass der Grundkörper mit der Anlagefläche flächig mit der Bedienfeldplatte verbunden ist. Die Bedienfeldplatte kann bei Verwendung eines 3K-Spritzgussverfahrens mit einem geeigneten transparenten und elektrisch isolierenden Kunststoffmaterial ausgebildet und stoffschlüssig mit dem Grundkörper verbunden sein. Es ist ebenfalls denkbar, dass der Grundkörper mit einer gesondert hergestellten Bedienfeldplatte verklebt oder formschlüssig daran festgelegt ist. Auf diese Weise wird eine weitgehend vormontierte Bedieneinrichtung hergestellt, die anschließend lediglich in einer daran angepassten Ausnehmung in einem Gehäuse oder in einer Wandung angeordnet und festgelegt werden muss.

Nach einer besonders vorteilhaften Ausgestaltung der erfindungsgemäßen Bedieneinrichtung kann vorgesehen sein, dass die Bedieneinrichtung eine Abdeckung aufweist, welche die Leiterplatte umgibt und an dem Grundkörper festgelegt ist. Mit der Abdeckung kann die Bedieneinrichtung gezielt und effektiv in einer Maschine oder in einem Gerät integriert werden, ohne dass in der Umgebung der Bedieneinrichtung besondere Anforderungen erfüllt oder gesonderte Schutzmaßnahmen erforderlich werden müssen.

Nachfolgend zeigen schematische Darstellungen eine Ausgestaltung des erfindungsgemäßen Verfahrens sowie exemplarische Ausgestaltungen der erfindungsgemäßen Bedieneinrichtung. Es zeigt:
Fig. 1 ein erfindungsgemäßes Verfahren zur Herstellung und Montage einer Bedieneinrichtung mit mehreren kapazitiven Sensorelementen zum Erfassen einer Berührung oder Annäherung an ein Bedienfeld der Bedieneinrichtung,
Fig. 2 zur Verdeutlichung des in Fig. 1 gezeigten Verfahrensablaufs eine Bedieneinrichtung, wobei nur ein kapazitives Sensorelement zum Erfassen einer Berührung oder Annäherung an ein Bedienfeld der Bedieneinrichtung dargestellt ist,
Fig. 3 ein Grundkörperkopplungselement hergestellt mit einem 2K-Spritzgussverfahren,
Fig. 4 eine erfindungsgemäße Bedieneinrichtung mit einer Abdeckung in einer auseinandergezogenen Darstellung,
Fig. 5 eine erfindungsgemäße Bedieneinrichtung in einer auseinandergezogenen perspektivischen Schnittansicht, und
Fig. 6 eine abweichende Ausgestaltung der erfindungsgemäßen Bedieneinrichtung in einer auseinandergezogenen perspektivischen Ansicht.

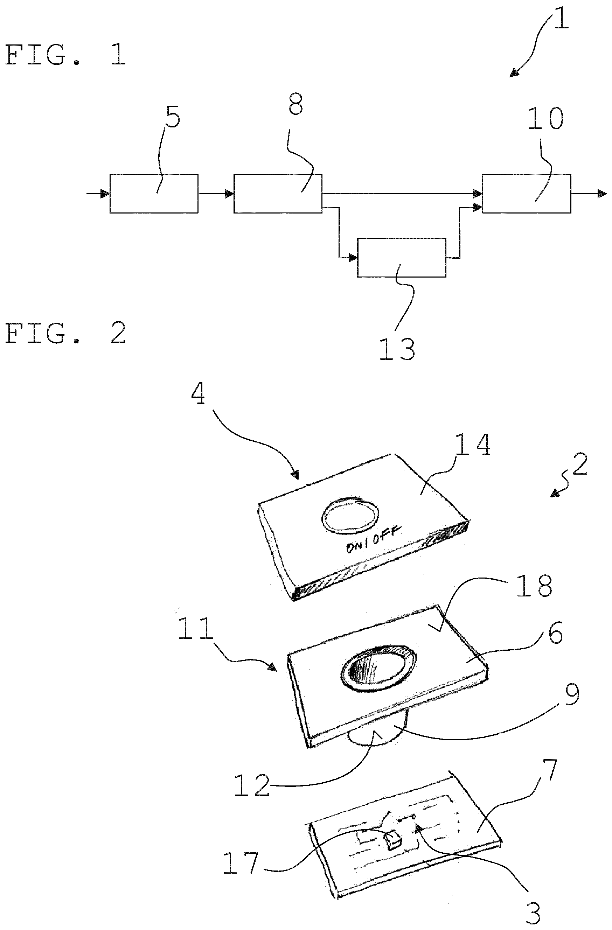

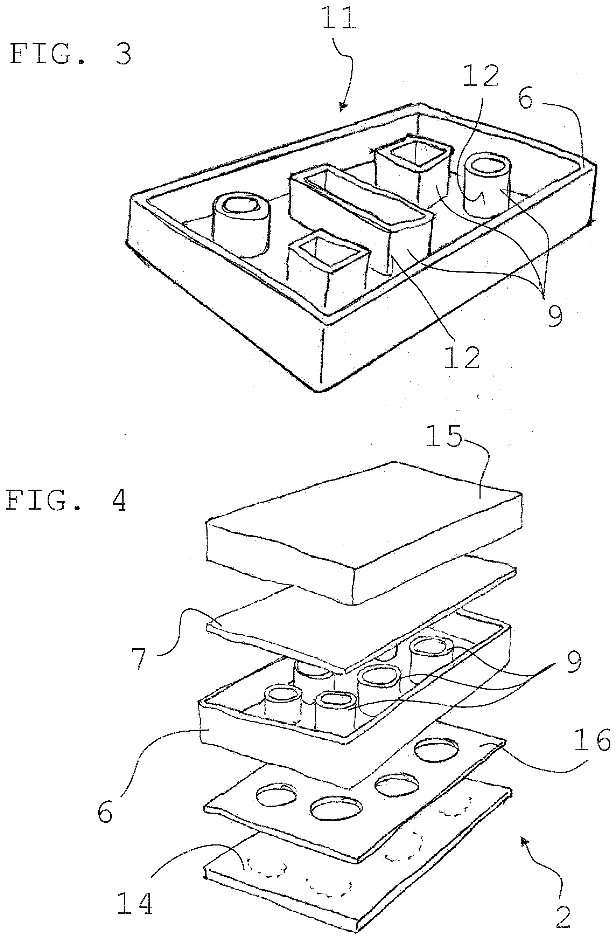

Figur 1 zeigt ein Ablaufdiagram 1 eines erfindungsgemäßen Verfahrens zur Herstellung und Montage einer in verschiedenen Varianten in den Figuren 3 bis 6 exemplarisch dargestellten Bedieneinrichtung 2 mit mehreren kapazitiven Sensorelementen 3 zum Erfassen einer Berührung oder Annäherung an ein Bedienfeld 4 der Bedieneinrichtung **2.** Figur 2 zeigt zur Veranschaulichung eine Bedieneinrichtung 2 mit einem kapazitiven Sensorelement 3 zum Erfassen einer Berührung oder Annäherung an das Bedienfeld 4 der Bedieneinrichtung 2, die nach dem erfindungsgemäßen Verfahren hergestellt wurde.

In einem Herstellungsschritt 5 werden jeweils gesondert ein Grundkörper 6 mit mehreren Kopplungselementen 9 sowie eine Leiterplatte 7 hergestellt. Die Kopplungselemente 9 können in dem Herstellungsschritt 5 unabhängig von dem Grundkörper 6 beispielsweise als metallische Hülse hergestellt und in einem nachfolgenden Kopplungselementanordnungsschritt 8 an oder in einem mit einem Spritzgussverfahren aus Kunststoff hergestellten Grundkörper 6 eingebettet werden. In dem Kopplungselementanordnungsschritt 8 können auch jeweils als metallisches Einlegeteil ausgebildete Kopplungselemente 9 mit einem den Grundkörper 6 bildenden Kunststoffmaterial umspritzt werden und dadurch das einstückig ausgestaltete Grundkörperkopplungselement 11 gebildet werden. Dadurch wird ein einstückiges Grundkörperkopplungselement 11 mit in dem Grundkörper 6 angeordneten Kopplungselementen 9 hergestellt. In einem abschließenden Montageschritt 10 wird die Leiterplatte 7 mit dem Grundkörperkopplungselement 11 verbunden und die kapazitiven Sensorelemente 3 auf der Leiterplatte 7 elektrisch leitend mit mindestens einem in dem Grundkörperkopplungselement 11 eingebetteten oder darin ausgebildeten und elektrisch leitenden Kopplungselement 9 verbunden. In dem Montageschritt 10 wird die Leiterplatte 7 beispielsweise rastend oder klebend an dem Grundkörperkopplungselement 11 festgelegt, wobei dabei die kapazitiven Sensorelemente 3 auf der Leiterplatte 7 an die elektrisch leitenden Kopplungselemente 9 des Grundkörperkopplungselements 11 angedrückt werden.

In dem Kopplungselementanordnungsschritt 8 kann auch ein Grundkörperkopplungselement 11 mit einem 2K-Spritzgussverfahren aus zwei verschiedenen Kunststoffmaterialien hergestellt werden, wobei für den Grundkörper ein elektrisch nicht leitendes Kunststoffmaterial und für die Kopplungselemente 9 ein elektrisch leitfähiges Kunststoffmaterial verwendet wird.

In dem Kopplungselementanordnungsschritt 8 kann gegebenenfalls auch lediglich der Grundkörper das Grundkörperkopplungselement 11 mit einem 2K-Spritzgussverfahren hergestellt werden, wobei die Kopplungsflächen 12 der Kopplungselemente 9 mit einem galvanisierbaren Kunststoffmaterial und der Grundkörper 6 aus einem nicht galvanisierbaren Kunststoffmaterial ausgebildet werden. Nachfolgend werden in einem dann zusätzlich erforderlichen Beschichtungsschritt 13 die Kopplungsflächen 12 der Kopplungselemente 9 mit einer elektrisch leitfähigen Beschichtung galvanisiert und aus dem galvanisierbaren Kunststoffmaterial zusammen mit der elektrisch leitfähigen Beschichtung die elektrisch leitfähigen Kopplungselemente 9 ausgebildet. Die elektrisch leitfähige Beschichtung kann auch durch andere Beschichtungsverfahren aufgebracht oder erzeugt werden, sodass das Kunststoffmaterial nicht notwendigerweise galvanisierbar sein muss.

In Figur 3 ist das Grundkörperkopplungselement 11 nochmals separat und in einer perspektivischen Darstellung gezeigt. Das galvanisierbare Kunststoffmaterial der Kopplungselemente 9 ist mit einer elektrisch leitfähigen Beschichtung überzogen, während der Grundkörper 6 aus einem nicht galvanisierbaren Kunststoffmaterial besteht. Dadurch wirkt nur die elektrisch leitfähige Kopplungsfläche 12 der Kopplungselemente 9 elektrisch leitend zu den kapazitiven Sensorelementen 3 auf der Leiterplatte 7.

Figur 4 zeigt eine erfindungsgemäße Bedieneinrichtung 2 mit einer die Leiterplatte 7 bedeckenden Abdeckung 15 in einer auseinandergezogenen Darstellung. Die Abdeckung 15 umschließt die Leiterplatte 7 und den Grundkörper 6 mit seinen Kopplungselementen 9. Der Grundkörper 6 ist mit einer Klebefolie 16 an einer Bedienfeldplatte 14 festlegt. Die Klebefolie 16 fixiert den Grundkörper fest an der Bedienfeldplatte 14 und erhöht damit die Stabilität des Bedienfeldes 4 und der Bedieneinrichtung 2.

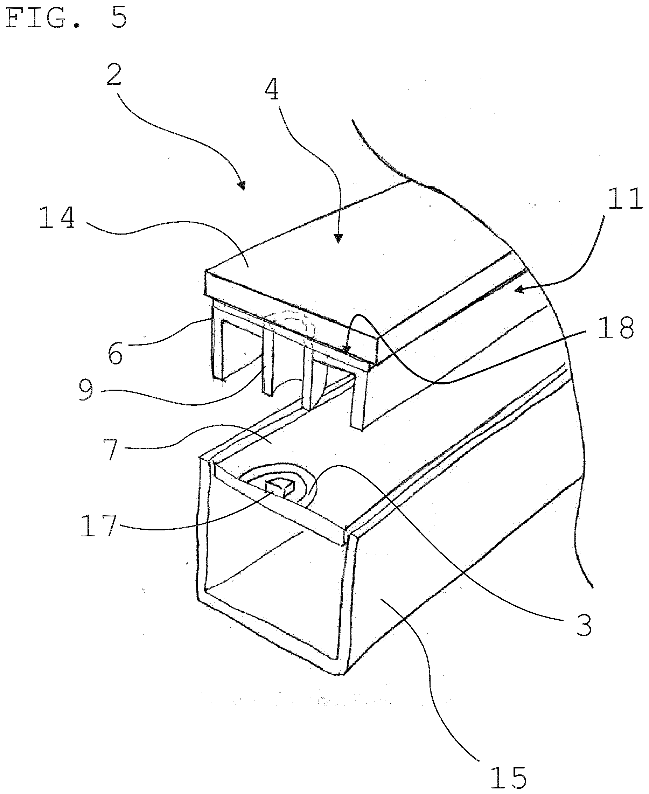

Figur 5 zeigt eine erfindungsgemäße Bedieneinrichtung 2 in einer auseinandergezogenen perspektivischen Schnittansicht, wobei die Kopplungselemente 9 in den Grundkörper 6 eingebettet ist. Die hülsenförmigen Kopplungselemente 9 bestehen aus einem in den Grundkörper 6 eingebetteten undurchsichtigen metallischen Einlegeteil, sodass eine auf der Leiterplatte 7 angeordnete Leuchtquelle 17, beispielsweise eine lichtemittierende Diode, jeweils von einem Kopplungselement 9 umgeben ist und das von der Leuchtquelle 17 abgestrahlte Licht auf einen durch die Querschnittsfläche des Kopplungselements 9 vorgegebenen Bereich auf der Rückseite der durchsichtigen Bedienfeldplatte 14 geleitet wird. Jedes Kopplungselement 9 verbindet einerseits ein kapazitives Sensorelement 3 mit einer dem Grundkörperkopplungselement 11 zugewandten und dem Bedienfeld 4 abgewandten Anlagefläche 18 der Bedienfeldplatte 14 und wirkt andererseits für die benachbarten Leuchtquellen 17 lichtabschirmend, sodass lediglich der von dem Kopplungselement 9 vorgegebene Bereich der Bedienfeldplatte 14 von der Leuchtquelle 17 von hinten ausgeleuchtet werden kann.

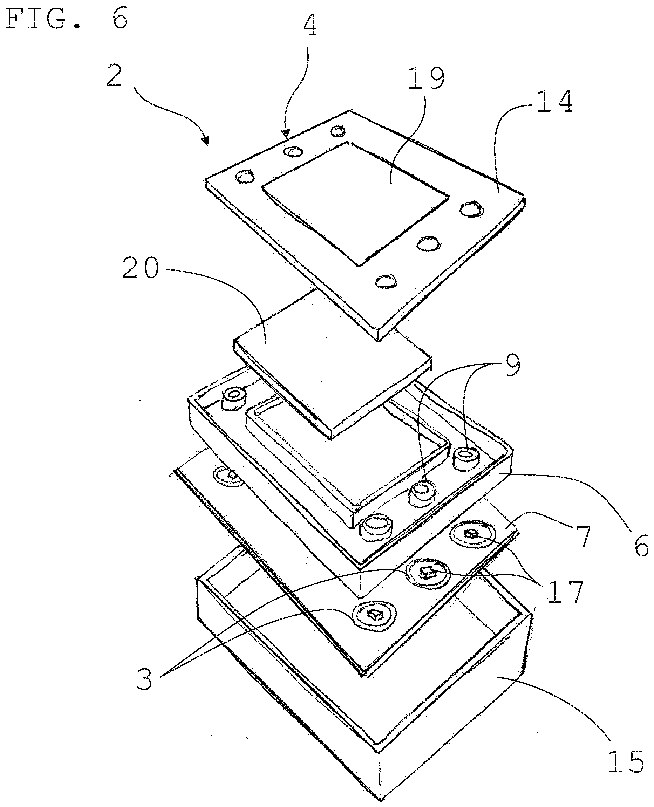

In Figur 6 ist exemplarisch eine abweichende Ausgestaltung der erfindungsgemäßen Bedieneinrichtung 2 dargestellt. Die Bedieneinrichtung 2 entspricht in vielen Details der bereits in Figur 5 gezeigten und beschriebenen Bedieneinrichtung **2.** Abweichend dazu weist die Bedienfeldplatte 14 eine Ausnehmung 19 auf, in welche flächenbündig ein berührungssensitives Display 20 eingesetzt ist. An Stelle einer Ausnehmung 19 kann auch eine Ausklinkung in der Bedienfeldplatte 14 vorgesehen sein oder ein Bereich der Bedienfeldplatte 14 aus einem durchsichtigen Material bestehen, hinter welchem ein näherungssensitives Display angeordnet werden kann. Auf diese Weise ist es möglich, sehr vielfältig verwendbare Bedieneinrichtungen 2 mit einer Kombination aus einem oder mehreren berührungssensitiven Displays 20 einerseits und einem berührungssensitiven Bedienfeld 4 andererseits kostengünstig herzustellen. Während in dem berührungssensitiven Display 20 komplexe Bedienfolgen grafisch dargestellt und von einem Benutzer ausgewählt bzw. vorgegeben werden können, kann durch ein Berühren des Bedienfelds 4 rasch eine einzige Aktion ausgewählt und vorgegeben werden, die bei einer bestimmungsgemäßen Verwendung der Bedieneinrichtung 2 beispielsweise häufig ausgewählt wird oder besonders rasch ausgewählt werden muss.

### B E Z U G S Z E I C H E N L I S T E

1. Ablaufdiagramm
2. Bedieneinrichtung
3. Sensorelement
4. Bedienfeld
5. Herstellungsschritt
6. Grundkörper
7. Leiterplatte
8. Montageschritt
9. Kopplungselement
10. Kopplungselementanordnungsschritt
11. Grundkörperkopplungselement
12. Kopplungsfläche
13. Beschichtungsschritt
14. Bedienfeldplatte
15. Abdeckung
16. Klebefolie
17. Leuchtquelle
18. Anlagefläche
19. Ausnehmung
20. berührungssensitives Display

## Patentansprüche

1. Verfahren zur Herstellung und Montage einer Bedieneinrichtung (2) mit mindestens einem kapazitiven Sensorelement (3) zum Erfassen einer Berührung oder Annäherung an ein Bedienfeld (4) der Bedieneinrichtung (2), wobei die Bedieneinrichtung (2) einen Grundkörper (6) und eine Leiterplatte (7) aufweist, wobei der Grundkörper (6) mit einer Anlagefläche (18) an einer Kontaktfläche des Bedienfelds festgelegt werden kann, wobei die Leiterplatte (7) mit mindestens einer Leuchtquelle zur Beleuchtung des Bedienfelds (4) in einem Abstand zu der Anlagefläche (18) an dem Grundkörper (6) angeordnet und festgelegt werden kann, und wobei zwischen der Anlagefläche (18) des Grundkörpers (6) und dem mindestens einen kapazitiven Sensorelement (3), welches auf der Leiterplatte (7) angeordnet ist, mindestens ein elektrisch leitendes Kopplungselement (9) angeordnet ist, um eine Kapazitätsänderung im Bereich des Bedienfelds (4) zu dem mindestens einen kapazitiven Sensorelement (3) zu übertragen, wobei mit dem Verfahren in einem Herstellungsschritt (5) der Grundkörper (6) und die Leiterplatte (7) hergestellt werden, und wobei in einem Montageschritt (10) die Leiterplatte (7) mit dem Grundkörper (6) verbunden und das mindestens eine kapazitive Sensorelement (3) auf der Leiterplatte (7) kapazitiv koppelnd oder elektrisch leitend mit dem mindestens einen elektrisch leitenden Kopplungselement (9) verbunden wird, wobei das mindestens eine Kopplungselement (9) in einem Kopplungselementanordnungsschritt (8) an oder in dem mit einem Spritzgussverfahren aus Kunststoff hergestellten Grundkörper (6) ausgebildet oder eingebettet wird und dadurch ein einstückiges Grundkörperkopplungselement (11) hergestellt wird, und wobei in dem nachfolgenden Montageschritt (10) die Leiterplatte (7) an dem Grundkörperkopplungselement (11) festgelegt und dabei das mindestens eine kapazitive Sensorelement (3) an das mindestens eine elektrisch leitende Kopplungselement (9) angedrückt wird, **dadurch gekennzeichnet, dass** auf der Leiterplatte (7) mehrere kapazitive Sensorelemente (3) angeordnet werden, dass in dem Kopplungselementanordnungsschritt (8) mehrere elektrisch leitende Kopplungselemente (9) an oder in dem mit einem Spritzgussverfahren aus Kunststoff hergestellten Grundkörper (6) ausgebildet oder eingebettet werden, und dass der Grundkörper (6) aus einem lichtundurchlässigen Kunststoffmaterial hergestellt wird und dass die Kopplungselemente (9) in dem Kopplungselementanordnungsschritt (8) derart ausgebildet werden, dass die Kopplungselemente (9) einen sich von der Leiterplatte (7) bis zu einer Ausnehmung in der Anlagefläche (18) des Grundkörpers (6) erstreckenden Hohlraum mit einer lichtundurchlässigen Umwandung hülsenförmig umgeben.

2. Verfahren nach Anspruch 1, **dadurch gekennzeichnet, dass** in dem Kopplungselementanordnungsschritt (8) die elektrisch leitfähigen Kopplungselemente (9) jeweils als metallisches Einlegeteil in eine Spritzgussform eingelegt und während der Herstellung des Grundkörpers (6) in dieser Spritzgussform an oder in diesem Grundkörper (6) eingebettet werden.

3. Verfahren nach Anspruch 1, **dadurch gekennzeichnet, dass** in dem Kopplungselementanordnungsschritt (8) der Grundkörper (6) mit den Kopplungselementen (9) mit einem Spritzgussverfahren aus einem elektrisch nicht leitfähigen Kunststoffmaterial hergestellt wird, und dass anschließend in einem Beschichtungsschritt (13) die Kopplungsfläche (12) der Kopplungselemente (9) mit einer elektrisch leitfähigen Beschichtung galvanisiert wird.

4. Verfahren nach Anspruch 1, **dadurch gekennzeichnet, dass** in dem Kopplungselementanordnungsschritt (8) der Grundkörper (6) mit einem 2K-Spritzgussverfahren hergestellt wird, wobei die Kopplungsflächen (12) der Kopplungselemente (9) mit einem elektrisch leitfähigen Kunststoffmaterial und der Grundkörper (6) aus einem nicht elektrisch leitfähigen Kunststoffmaterial ausgebildet werden.

5. Verfahren nach Anspruch 1, **dadurch gekennzeichnet, dass** in dem Kopplungselementanordnungsschritt (8) der Grundkörper (6) mit einem 2K-Spritzgussverfahren hergestellt wird, wobei eine Kopplungsfläche (12) der Kopplungselemente (9) mit einem galvanisierbaren Kunststoffmaterial und der Grundkörper (6) aus einem nicht galvanisierbaren Kunststoffmaterial ausgebildet wird, und anschließend in einem Beschichtungsschritt (13) die Kopplungsflächen (12) der Kopplungselemente (9) mit einer elektrisch leitfähigen Beschichtung galvanisiert werden.

6. Verfahren nach einem der Ansprüche 3 bis 5, **dadurch gekennzeichnet, dass** die Kopplungsflächen (12) der Kopplungselemente (9) so ausgebildet werden, dass die elektrisch leitfähige Beschichtung für einen Kontakt mit dem kapazitiven Sensorelement (3) von außen elektrisch leitend kontaktierbar ist.

7. Verfahren nach einem der Ansprüche 3 bis 6, **dadurch gekennzeichnet, dass** in einem Bedienfeldanordnungsschritt ein Bedienelementkörper mit dem Grundkörper (6), mit den Kopplungselementen (9) und mit einer Bedienfeldplatte (14) mit einem 3K-Spritzgussverfahren hergestellt wird und anschließend der Beschichtungsschritt (13) durchgeführt wird.

8. Verfahren nach einem der vorausgehenden Ansprüche, **dadurch gekennzeichnet, dass** in dem Montageschritt (10) der Grundkörper (6) mit der Anlagefläche (18) an die Bedienfeldplatte (14) angeklebt wird.

9. Verfahren nach Anspruch 2, **dadurch gekennzeichnet, dass** die elektrisch leitfähigen Kopplungselemente (9) derart in an oder in dem Grundkörper (6) eingebettet werden, dass eine Kontaktfläche des jeweiligen elektrisch leitfähigen Kopplungselements (9) für einen Kontakt mit dem kapazitiven Sensorelement von außen elektrisch leitend kontaktierbar ist.

10. Bedieneinrichtung (2) mit mindestens einem kapazitiven Sensorelement (3) zum Erfassen einer Berührung oder Annäherung an ein Bedienfeld (4) der Bedieneinrichtung (2), wobei die Bedieneinrichtung (2) einen Grundkörper (6) und eine Leiterplatte (7) aufweist, wobei der Grundkörper (6) mit einer Anlagefläche (18) an einer Kontaktfläche des Bedienfelds (4) festgelegt werden kann, wobei die Leiterplatte (7) in einem Abstand zu der Anlagefläche (18) an dem Grundkörper (6) angeordnet und festgelegt werden kann, und wobei zwischen der Anlagefläche (18) des Grundkörpers (6) und dem mindestens einen kapazitiven Sensorelement (3), welches auf der Leiterplatte (7) angeordnet ist, mindestens ein elektrisch leitendes Kopplungselement (9) angeordnet ist, um eine Kapazitätsänderung im Bereich des Bedienfelds (4) zu dem mindestens einen kapazitiven Sensorelement (3) zu übertragen, wobei das mindestens eine Kopplungselement (9) an oder in dem mit einem Spritzgussverfahren aus Kunststoff hergestellten Grundkörper (6) ausgebildet oder eingebettet ist und ein einstückiges Grundkörperkopplungselement (11) bildet, und wobei die Leiterplatte (7) an dem Grundkörperkopplungselement (11) festgelegt ist und dabei das mindestens eine kapazitive Sensorelement (3) an das mindestens eine elektrisch leitende Kopplungselement (9) angedrückt ist, **dadurch gekennzeichnet, dass** auf der Leiterplatte (7) mehrere kapazitive Sensorelemente (3) angeordnet sind, dass mehrere elektrisch leitende Kopplungselemente (9) an oder in dem mit einem Spritzgussverfahren aus Kunststoff hergestellten Grundkörper (6) ausgebildet oder eingebettet sind, und dass der Grundkörper (6) aus einem lichtundurchlässigen Kunststoffmaterial hergestellt ist und dass die Kopplungselemente (9) derart ausgebildet sind, dass die Kopplungselemente (9) jeweils einen sich von der Leiterplatte (7) bis zu einer Ausnehmung in der Anlagefläche (18) des Grundkörpers (6) erstreckenden Hohlraum mit einer lichtundurchlässigen Umwandung hülsenförmig umgeben.

11. Bedieneinrichtung (2) nach Anspruch 10, **dadurch gekennzeichnet, dass** die elektrisch leitfähigen Kopplungselemente (9) jeweils als metallisches Einlegeteil an oder in diesem Grundkörper (6) eingebettet sind.

12. Bedieneinrichtung (2) nach Anspruch 10, **dadurch gekennzeichnet, dass** der Grundkörper (6) mit einem Spritzgussverfahren aus einem nicht elektrisch leitfähigen Kunststoffmaterial hergestellt ist, und dass eine Kopplungsfläche (12) der Kopplungselemente (9) mit einer elektrisch leitfähigen Beschichtung beschichtet ist.

13. Bedieneinrichtung (2) nach Anspruch 10, **dadurch gekennzeichnet, dass** der Grundkörper (6) mit einem 2K-Spritzgussverfahren hergestellt ist, wobei eine Kopplungsfläche (12) der Kopplungselemente (9) aus einem elektrisch leitfähigen Kunststoffmaterial und der Grundkörper (6) aus einem nicht elektrisch leitfähigen Kunststoffmaterial ausgebildet ist.

14. Bedieneinrichtung (2) nach Anspruch 10, **dadurch gekennzeichnet, dass** der Grundkörper (6) mit einem 2K-Spritzgussverfahren hergestellt ist, wobei eine Kopplungsfläche (12) der Kopplungselemente (9) aus einem galvanisierbaren Kunststoffmaterial und der Grundkörper (6) aus einem nicht galvanisierbaren Kunststoffmaterial ausgebildet ist, und die Kopplungsfläche der Kopplungselemente (9) mit einer elektrisch leitfähigen Beschichtung galvanisiert ist.

15. Bedieneinrichtung (2) nach einem der Ansprüche 10 bis 14, **dadurch gekennzeichnet, dass** die Kopplungsfläche (12) der Kopplungselemente (9) so ausgebildet ist, dass die elektrisch leitfähige Beschichtung für einen Kontakt mit dem kapazitiven Sensorelement (3) von außen elektrisch leitend kontaktierbar ist.

16. Bedieneinrichtung (2) nach einem der Ansprüche 10 bis 15, **dadurch gekennzeichnet, dass** ein Bedienelementkörper mit dem Grundkörper (6), mit den Kopplungselementen (9) und mit einer Bedienfeldplatte (19) mit einem 2K-Spritzgussverfahren oder mit einem 3K-Spritzgussverfahren hergestellt ist.

17. Bedieneinrichtung (2) nach einem der Ansprüche 10 bis 16, **dadurch gekennzeichnet, dass** die Bedieneinrichtung (2) eine Bedienfeldplatte (14) aufweist und dass der Grundkörper (6) mit der Anlagefläche (18) flächig mit der Bedienfeldplatte (14) verbunden ist.

18. Bedieneinrichtung (2) nach Anspruch 11, **dadurch gekennzeichnet, dass** die elektrisch leitfähigen Kopplungselemente (9) derart in an oder in dem Grundkörper (6) eingebettet sind, dass eine Kontaktfläche der elektrisch leitfähigen Kopplungselemente (9) für einen Kontakt mit dem kapazitiven Sensorelement (3) von außen elektrisch leitend kontaktierbar ist.

19. Bedieneinrichtung (2) nach einem der Ansprüche 10 bis 18, **dadurch gekennzeichnet, dass** die Bedieneinrichtung (2) eine Abdeckung (15) aufweist, welche die Leiterplatte (7) umgibt und an dem Grundkörper (6) festgelegt ist.

## Claims

1. Method for producing and assembling a control device (2) comprising at least one capacitive sensor element (3) for detecting a control panel (4) of the control device (2) being touched or approached, wherein the control device (2) comprises a main body (6) and a printed circuit board (7), wherein the main body (6) can be fixed to a contact surface of the control panel by a seating surface (18), wherein the printed circuit board (7), comprising at least one light source for illuminating the control panel (4), can be arranged on and fixed to the main body (6) at a distance from the seating surface (18), and wherein at least one electrically conductive coupling element (9) is arranged between the seating surface (18) of the main body (6) and the at least one capacitive sensor element (3), which is arranged on the printed circuit board (7), in order to transmit a change in capacitance in the region of the control panel (4) to the at least one capacitive sensor element (3), wherein, using the method, the main body (6) and the printed circuit board (7) are produced in one production step (5), and wherein, in an assembly step (10), the printed circuit board (7) is connected to the main body (6) and the at least one capacitive sensor element (3) on the printed circuit board (7) is capacitively couplingly or electrically conductively connected to the at least one electrically conductive coupling element (9), wherein, in a coupling-element arranging step (8), the at least one coupling element (9) is formed on or embedded in the main body (6) produced from plastics material in an injection-moulding process and a one-piece main-body coupling element (11) is thus produced, and wherein, in the subsequent assembly step (10), the printed circuit board (7) is fixed to the main-body coupling element (11) and, in the process, the at least one capacitive sensor element (3) is pressed against the at least one electrically conductive coupling element (9), **characterised in that** a plurality of capacitive sensor elements (3) are arranged on the printed circuit board (7), **in that**, in the coupling-element arranging step (8), a plurality of electrically conductive coupling elements (9) are formed on or embedded in the main body (6) produced from plastics material in an injection-moulding process, and **in that** the main body (6) is produced from a non-transparent plastics material and **in that** the coupling elements (9) are formed in the coupling-element arranging step (8) such that the coupling elements (9) surround, in a sleeve-shaped manner, a cavity which extends from the printed circuit board (7) up to a recess in the seating surface (18) of the main body (6) and comprises a non-transparent wall.

2. Method according to claim **1, characterised in that**, in the coupling-element arranging step (8), the electrically conductive coupling elements (9) are each placed into an injection mould as a metal insert and, during production of the main body (6), are embedded on or in this main body (6) in this injection mould.

3. Method according to claim 1, **characterised in that**, in the coupling-element arranging step (8), the main body (6) together with the coupling elements (9) are produced from an electrically non-conductive plastics material using an injection-moulding process, and **in that**, in a coating step (13), the coupling surface (12) of the coupling elements (9) is then galvanised by an electrically conductive coating.

4. Method according to claim **1, characterised in that**, in the coupling-element arranging step (8), the main body (6) is produced using a two-component injection-moulding process, wherein the coupling surfaces (12) of the coupling elements (9) are formed by an electrically conductive plastics material and the main body (6) is made of an electrically non-conductive plastics material.

5. Method according to claim **1, characterised in that**, in the coupling-element arranging step (8), the main body (6) is produced using a two-component injection-moulding process, wherein a coupling surface (12) of the coupling elements (9) is formed by a galvanisable plastics material and the main body (6) is made of a non-galvanisable plastics material, and, in a coating step (13), the coupling surfaces (12) of the coupling elements (9) are then galvanised by an electrically conductive coating.

6. Method according to any of claims 3 to 5, **characterised in that** the coupling surfaces (12) of the coupling elements (9) are formed such that the electrically conductive coating is electrically conductively contactable from the outside for contact with the capacitive sensor element (3).

7. Method according to any of claims 3 to 6, **characterised in that**, in a control-panel arranging step, a control-element body comprising the main body (6), the coupling elements (9) and a control-panel plate (14) is produced using a three-component injection-moulding process and the coating step (13) is then carried out.

8. Method according to any of the preceding claims, **characterised in that**, in the assembly step (10), the main body (6) is bonded to the control-panel plate (14) by the seating surface (18).

9. Method according to claim 2, **characterised in that** the electrically conductive coupling elements (9) are embedded on or in the main body (6) such that a contact surface of the relevant electrically conductive coupling element (9) is electrically conductively contactable from the outside for contact with the capacitive sensor element.

10. Control device (2) comprising at least one capacitive sensor element (3) for detecting a control panel (4) of the control device (2) being touched or approached, wherein the control device (2) comprises a main body (6) and a printed circuit board (7), wherein the main body (6) can be fixed to a contact surface of the control panel (4) by a seating surface (18), wherein the printed circuit board (7) can be arranged on and fixed to the main body (6) at a distance from the seating surface (18), and wherein at least one electrically conductive coupling element (9) is arranged between the seating surface (18) of the main body (6) and the at least one capacitive sensor element (3), which is arranged on the printed circuit board (7), in order to transmit a change in capacitance in the region of the control panel (4) to the at least one capacitive sensor element (3), wherein the at least one coupling element (9) is formed on or embedded in the main body (6) produced from plastics material in an injection-moulding process and forms a one-piece main-body coupling element (11), and wherein the printed circuit board (7) is fixed to the main-body coupling element (11) and, in the process, the at least one capacitive sensor element (3) is pressed against the at least one electrically conductive coupling element (9), **characterised in that** a plurality of capacitive sensor elements (3) are arranged on the printed circuit board (7), **in that** a plurality of electrically conductive coupling elements (9) are formed on or embedded in the main body (6) produced from plastics material in an injection-moulding process, and **in that** the main body (6) is produced from a non-transparent plastics material and **in that** the coupling elements (9) are formed such that the coupling elements (9) each surround, in a sleeve-shaped manner, a cavity which extends from the printed circuit board (7) up to a recess in the seating surface (18) of the main body (6) and comprises a non-transparent wall.

11. Control device (2) according to claim 10, **characterised in that** the electrically conductive coupling elements (9) are each embedded on or in this main body (6) as a metal insert.

12. Control device (2) according to claim 10, **characterised in that** the main body (6) is produced from an electrically non-conductive plastics material using an injection-moulding process, and **in that** a coupling surface (12) of the coupling elements (9) is coated with an electrically conductive coating.

13. Control device (2) according to claim 10, **characterised in that** the main body (6) is produced using a two-component injection-moulding process, wherein a coupling surface (12) of the coupling elements (9) is made of an electrically conductive plastics material and the main body (6) is made of an electrically non-conductive plastics material.

14. Control device (2) according to claim 10, **characterised in that** the main body (6) is produced using a two-component injection-moulding process, wherein a coupling surface (12) of the coupling elements (9) is made of a galvanisable plastics material and the main body (6) is made of a non-galvanisable plastics material, and the coupling surface of the coupling elements (9) is galvanised by an electrically conductive coating.

15. Control device (2) according to any of claims 10 to 14, **characterised in that** the coupling surface (12) of the coupling elements (9) is formed such that the electrically conductive coating is electrically conductively contactable from the outside for contact with the capacitive sensor element (3).

16. Control device (2) according to any of claims 10 to 15, **characterised in that** a control-element body comprising the main body (6), the coupling elements (9) and a control-panel plate (19) is produced using a two-component injection-moulding process or a three-component injection-moulding process

17. Control device (2) according to any of claims 10 to 16, **characterised in that** the control device (2) comprises a control-panel plate (14) and **in that** the main body (6) is connected to the control-panel plate (14) in a planar manner by the seating surface (18).

18. Control device (2) according to claim 11, **characterised in that** the electrically conductive coupling elements (9) are embedded on or in the main body (6) such that a contact surface of the electrically conductive coupling elements (9) is electrically conductively contactable from the outside for contact with the capacitive sensor element (3).

19. Control device (2) according to any of claims 10 to 18, **characterised in that** the control device (2) comprises a cover (15), which surrounds the printed circuit board (7) and is fixed to the main body (6).

## Revendications

1. Procédé de fabrication et de montage d'un dispositif de commande (2) avec au moins un élément capteur (3) capacitif destiné à détecter un contact ou une proximité avec un panneau de commande (4) du dispositif de commande (2), dans lequel le dispositif de commande (2) présente un corps de base (6) et une carte de circuits imprimés (7), dans lequel le corps de base (6) peut être fixé avec une surface d'appui (18) sur une surface de contact du panneau de commande, dans lequel la carte de circuits imprimés (7) peut être disposée et fixé sur le corps de base (6) à une distance de la surface d'appui (18) avec au moins une source de lumière destinée à éclairer le panneau de commande (4), et dans lequel au moins un élément de couplage (9) électriquement conducteur est disposé entre la surface d'appui (18) du corps de base (6) et l'au moins un élément capteur (3) capacitif, lequel est disposé sur la carte de circuits imprimés (7) pour transmettre une modification de capacité dans la zone du panneau de commande (4) à l'au moins un élément capteur (3) capacitif, dans lequel le corps de base (6) et la carte de circuits imprimés (7) sont fabriqués avec le procédé dans une étape de fabrication (5), et dans lequel, dans une étape de montage (10), la carte de circuits imprimés (7) est reliée au corps de base (6) et l'au moins un élément capteur (3) capacitif est relié à l'au moins un élément de couplage (9) électriquement conducteur par couplage capacitif ou de manière électriquement conductrice sur la carte de circuits imprimés (7), dans lequel l'au moins un élément de couplage (9) est réalisé ou intégré, dans une étape de disposition d'élément de couplage (8), sur ou dans le corps de base (6) fabriqué en matière plastique avec un procédé de moulage par injection, et un élément de couplage de corps de base (11) d'un seul tenant est ainsi fabriqué, et dans lequel, dans l'étape de montage (10) qui suit, la carte de circuits imprimés (7) est fixée sur l'élément de couplage de corps de base (11) et ainsi l'au moins un élément capteur (3) capacitif est appliqué par pression sur l'au moins un élément de couplage (9) électriquement conducteur, **caractérisé en ce que** plusieurs éléments capteurs (3) capacitifs sont disposés sur la carte de circuits imprimés (7), que, dans l'étape de disposition d'élément de couplage (8), plusieurs éléments de couplage (9) électriquement conducteurs sont réalisés ou intégrés sur ou dans le corps de base (6) fabriqué en matière plastique avec un procédé de moulage par injection, et que le corps de base (6) est fabriqué à partir d'un matériau en matière plastique non translucide, et que les éléments de couplage (9) sont réalisés de telle manière dans l'étape de disposition d'élément de couplage (8) que les éléments de couplage (9) entourent en forme de douille un espace creux, s'étendant depuis la carte de circuits imprimés (7) jusqu'à un évidement dans la surface d'appui (18) du corps de base (6), avec une paroi périphérique non translucide.

2. Procédé selon la revendication 1, **caractérisé en ce que**, dans l'étape de disposition d'élément de couplage (8), les éléments de couplage (9) électriquement conducteurs sont insérés dans un moule de moulage par injection respectivement en tant qu'une pièce d'insertion métallique et sont intégrés sur ou dans ledit corps de base (6) dans ledit moule de moulage par injection pendant la fabrication du corps de base (6).

3. Procédé selon la revendication 1, **caractérisé en ce que**, dans l'étape de disposition d'élément de couplage (8), le corps de base (6) est fabriqué à partir d'un matériau en matière plastique électriquement non conducteur avec un procédé de moulage par injection avec les éléments de couplage (9), et qu'ensuite, dans une étape de revêtement (13), la surface de couplage (12) des éléments de couplage (9) est galvanisée avec un revêtement électriquement conducteur.

4. Procédé selon la revendication **1, caractérisé en ce que**, dans l'étape de disposition d'élément de couplage (8), le corps de base (6) est fabriqué avec un procédé de moulage par injection à deux composants, dans lequel les surfaces de couplage (12) des éléments de couplage (9) sont réalisées avec un matériau en matière plastique électriquement conducteur et le corps de base (6) est réalisé à partir d'un matériau en matière plastique non conducteur électriquement.

5. Procédé selon la revendication **1, caractérisé en ce que**, dans l'étape de disposition d'élément de couplage (8), le corps de base (6) est fabriqué avec un procédé de moulage par injection à deux composants, dans lequel une surface de couplage (12) des éléments de couplage (9) est réalisée avec un matériau en matière plastique pouvant être galvanisé et le corps de base (6) est réalisé à partir d'un matériau en matière plastique ne pouvant pas être galvanisé, puis, dans une étape de revêtement (13), les surfaces de couplage (12) des éléments de couplage (9) sont galvanisées avec un revêtement électriquement conducteur.

6. Procédé selon l'une quelconque des revendications 3 à 5, **caractérisé en ce que** les surfaces de couplage (12) des éléments de couplage (9) sont réalisées de telle sorte que le revêtement électriquement conducteur peut être mis en contact de manière électriquement conductrice depuis l'extérieur pour un contact avec l'élément capteur (3) capacitif.

7. Procédé selon l'une quelconque des revendications précédentes 3 à 6, **caractérisé en ce que**, dans une étape de disposition de panneau de commande, un corps d'élément de commande avec le corps de base (6), avec les éléments de couplage (9) et une plaque de panneau de commande (14) est fabriqué avec un procédé de moulage par injection à 3 composants puis l'étape de revêtement (13) est mise en œuvre.

8. Procédé selon l'une quelconque des revendications précédentes, **caractérisé en ce que**, dans l'étape de montage (10), le corps de base (6) est collé sur la plaque de panneau de commande (14) avec la surface d'appui (18).

9. Procédé selon la revendication 2, **caractérisé en ce que** les éléments de couplage (9) électriquement conducteurs sont intégrés de telle manière sur ou dans le corps de base (6) qu'une surface de contact de l'élément de couplage (9) électriquement conducteur respectif peut être mise en contact de manière électriquement conductrice depuis l'extérieur pour un contact avec l'élément capteur capacitif.

10. Dispositif de commande (2) avec au moins un élément capteur capacitif (3) destiné à détecter un contact ou une proximité avec un panneau de commande (4) du dispositif de commande (2), dans lequel le dispositif de commande (2) présente un corps de base (6) et une carte de circuits imprimés (7), dans lequel le corps de base (6) peut être fixé sur une surface de contact du panneau de commande (4) avec une surface d'appui (18), dans lequel la carte de circuits imprimés (7) peut être disposée et fixée sur le corps de base (6) à une distance par rapport à la surface d'appui (18), et dans lequel au moins un élément de couplage (9) électriquement conducteur est disposé entre la surface d'appui (18) du corps de base (6) et l'au moins un élément capteur (3) capacitif, lequel est disposé sur la carte de circuits imprimés (7) pour transmettre une modification de capacité dans la zone du panneau de commande (4) à l'au moins un élément capteur (3) capacitif, dans lequel l'au moins un élément de couplage (9) est réalisé ou intégré sur ou dans le corps de base (6) fabriqué en matière plastique avec un procédé de moulage par injection et forme un élément de couplage de corps de base (11) d'un seul tenant, et dans lequel la carte de circuits imprimés (7) est fixée sur l'élément de couplage de corps de base (11) et, dans ce cadre, l'au moins un élément capteur (3) capacitif est appliqué par pression sur l'au moins un élément de couplage (9) électriquement conducteur, **caractérisé en ce que** plusieurs éléments capteurs (3) capacitifs sont disposés sur la carte de circuits imprimés (7), que plusieurs éléments de couplage (9) électriquement conducteurs sont réalisés ou intégrés sur ou dans le corps de base (6) fabriqué en matière plastique avec un procédé de moulage par injection, et que le corps de base (6) est fabriqué à partir d'un matériau en matière plastique non translucide et que les éléments de couplage (9) sont réalisés de telle manière que les éléments de couplage (9) entourent en forme de douille avec une paroi périphérique non translucide respectivement un espace creux s'étendant depuis la carte de circuits imprimés (7) jusqu'à un évidement dans la surface d'appui (18) du corps de base (6).

11. Dispositif de commande (2) selon la revendication 10, **caractérisé en ce que** les éléments de couplage (9) électriquement conducteurs sont intégrés respectivement en tant que pièce d'insertion métallique sur ou dans ledit corps de base (6).

12. Dispositif de commande (2) selon la revendication 10, **caractérisé en ce que** le corps de base (6) est fabriqué à partir d'un matériau en matière plastique non conducteur électriquement avec un procédé de moulage par injection, et qu'une surface de couplage (12) des éléments de couplage (9) est revêtue avec un revêtement électriquement conducteur.

13. Dispositif de commande (2) selon la revendication 10, **caractérisé en ce que** le corps de base (6) est fabriqué avec un procédé de moulage par injection à 2 composants, dans lequel une surface de couplage (12) des éléments de couplage (9) est réalisée à partir d'un matériau en matière plastique électriquement conducteur et le corps de base (6) est réalisé à partir d'un matériau en matière plastique non conducteur électriquement.

14. Dispositif de commande (2) selon la revendication 10, **caractérisé en ce que** le corps de base (6) est fabriqué avec un procédé de moulage par injection à 2 composants, dans lequel une surface de couplage (12) des éléments de couplage (9) est réalisée à partir d'un matériau en matière plastique pouvant être galvanisé et le corps de base (6) est réalisé à partir d'un matériau en matière plastique ne pouvant pas être galvanisé, et la surface de couplage des éléments de couplage (9) est galvanisée avec un revêtement électriquement conducteur.

15. Dispositif de commande (2) selon l'une quelconque des revendications 10 à 14, **caractérisé en ce que** la surface de couplage (12) des éléments de couplage (9) est réalisée de telle sorte que le revêtement électriquement conducteur peut être mis en contact de manière électriquement conductrice depuis l'extérieur pour un contact avec l'élément capteur (3) capacitif.

16. Dispositif de commande (2) selon l'une quelconque des revendications 10 à 15, **caractérisé en ce qu'**un corps d'élément de commande avec le corps de base (6), avec les éléments de couplage (9) et avec une plaque de panneau de commande (19) est fabriqué avec un procédé de moulage par injection à 2 composants ou avec un procédé de moulage par injection à 3 composants.

17. Dispositif de commande (2) selon l'une quelconque des revendications 10 à 16, **caractérisé en ce que** le dispositif de commande (2) présente une plaque de panneau de commande (14), et que le corps de base (6) est relié à plat avec la plaque de panneau de commande (14) avec la surface d'appui (18).

18. Dispositif de commande (2) selon la revendication 11, **caractérisé en ce que** les éléments de couplage (9) électriquement conducteurs sont intégrés de telle manière sur ou dans le corps de base (6) qu'une surface de contact des éléments de couplage (9) électriquement conducteurs peut être mise en contact de manière électriquement conductrice depuis l'extérieur pour un contact avec l'élément capteur (3) capacitif.

19. Dispositif de commande (2) selon l'une quelconque des revendications 10 à 18, **caractérisé en ce que** le dispositif de commande (2) présente un recouvrement (15), qui entoure la carte de circuits imprimés (7) et est fixé sur le corps de base (6).
